Europäisches Patentamt

European Patent Office

Office européen des brevets

(19)

(11) Numéro de publication : **0 356 266 B1**

# FASCICULE DE BREVET EUROPEEN

(12)

(45) Date de publication du fascicule du brevet :
**02.12.92 Bulletin 92/49**

(51) Int. Cl.⁵ : **H03H 9/05**

(21) Numéro de dépôt : **89401636.9**

(22) Date de dépôt : **13.06.89**

---

(54) **Filtre compact à résonateurs utilisant l'effet piézoélectrique.**

---

(30) Priorité : **01.07.88 FR 8808915**

(43) Date de publication de la demande :
**28.02.90 Bulletin 90/09**

(45) Mention de la délivrance du brevet :
**02.12.92 Bulletin 92/49**

(84) Etats contractants désignés :
**AT BE CH DE ES FR GB IT LI NL SE**

(56) Documents cités :
**FR-A- 2 547 458**
**GB-A- 704 975**
**US-A- 4 112 324**
**US-A- 4 471 259**
**PATENT ABSTRACTS OF JAPAN, vol. 4, no.**
**175 (E-36)[657], 3 décembre 1980, page 119 E**
**36; & JP-A-55 121 730 (NIPPON DENKIK.K.)**
**19-09-1980**

(73) Titulaire : **COMPAGNIE D'ELECTRONIQUE ET**
**DE PIEZO-ELECTRICITE - C.E.P.E.**
**44, avenue de la Glacière**
**F-95100 Argenteuil (FR)**

(72) Inventeur : **Michel, Jean-Philippe**
**THOMSON-CSF SCPI CEDEX 67**
**F-92045 Paris la Défense (FR)**
Inventeur : **Brauge, Jean**
**THOMSON-CSF SCPI CEDEX 67**
**F-92045 Paris la Défense (FR)**
Inventeur : **Aubry, Jean-Pierre**
**THOMSON-CSF SCPI CEDEX 67**
**F-92045 Paris la Défense (FR)**
Inventeur : **Gelle, Claude**
**THOMSON-CSF SCPI CEDEX 67**
**F-92045 Paris la Défense (FR)**

(74) Mandataire : **Guérin, Michel et al**
**THOMSON-CSF SCPI**
**F-92045 PARIS LA DEFENSE CEDEX 67 (FR)**

## Description

La présente invention concerne un filtre compact à résonateurs, utilisant l'effet piézo-électrique.

Les filtres à résonateurs utilisant l'effet piézoélectrique connus sont généralement constitués de lames vibrantes excitées par effet piézoélectrique, encapsulées individuellement dans un boîtier composé d'un capot reposant sur une embase. Le capot est assez souvent métallique et est porté à la masse. L'embase est traversée par deux ou trois broches de sortie. Le boîtier est fermé de façon hermétique. Plusieurs résonateurs ainsi encapsulés sont montés sur une plaque de circuit imprimé. Des composants discrets sont aussi connectés sur la plaque de circuit imprimé. Ils servent au couplage et à l'adaptation du filtre. Après le réglage des résonateurs, la plaque de circuit imprimé surmontée des composants et des résonateurs est enfermée dans un autre boîtier qui est généralement métallique. Ce boîtier n'est pas forcément étanche. Les sorties se font à l'aide de broches.

Un inconvénient majeur de ce genre de montage est son volume. Les composants et les lames encapsulées prennent beaucoup de place, dans toutes les dimensions. De plus, il est nécessaire de régler chaque lame vibrante une par une, avant son encapsulation et ensuite il n'est plus possible de modifier ce réglage.

La présente invention, au contraire propose un filtre compact à résonateurs utilisant l'effet piézoélectrique . Ce filtre se présente sous la forme d'un boîtier plat qui peut avoir une structure compatible avec celle des composants montés en surface. Il est constitué de lames vibrantes, excitées par effet piézoélectrique, montées sur un même substrat, ce substrat étant ensuite encapsulé, le tout étant très plat.

La présente invention propose un filtre à résonateurs utilisant l'effet piézoélectrique constitué d'un substrat isolant comportant un ou plusieurs composants actifs ou passifs et au moins une lame vibrante excitée par effet piézoéelectrique, disposée dans un trou percé au travers les faces principales du substrat, des bornes d'entrée-sortie, des connexions reliant les bornes d'entrée-sortie à la lame vibrante et au ou aux composants caractérisé en ce que chaque trou est constitué de deux évidements de taille différente, en vis à vis, le premier situé sur la face supérieure du substrat est supérieur ou égal à la surface de la lame vibrante, le deuxième situé sur la face inférieure du substrat présente une découpe fournissant au moins une surface d'appui, située à un niveau intermédiaire sur laquelle est fixée la lame vibrante, par au moins deux points d'attache et en ce que les connexions sont réalisées par des pistes conductrices déposées sur les faces principales ou à l'intérieur du substrat, et sur la surface d'appui.

Le substrat en matériau diélectrique peut être soit monobloc soit constitué d'un empilement de couches.

Le ou les composants peuvent être des composants rapportés sur les faces du substrat ou dans un évidement prévu à cet effet. Les composants peuvent être aussi réalisés par métallisation d'un motif à la surface du substrat ou entre une ou plusieurs couches.

Le substrat peut être enfermé dans un boîtier. Chaque face principale du substrat peut être recouverte d'un ou plusieurs capots. Le boîtier ou les capots peuvent être remplis d'un gaz neutre ou être fermés sous vide.

L'invention sera mieux comprise et d'autres avantages apparaîtront à la lecture de la description qui va suivre illustrée par les figures annexées suivantes :
- la figure 1 est une vue en perspective partiellement coupée, d'un filtre à résonateurs selon l'invention, le substrat étant monobloc et placé dans un boitier;
- la figure 2 est un éclaté partiel d'un filtre à résonateurs selon l'invention, le substrat étant constitué d'un empilement de couches ;
- les figures 3a et 3b représentent en perspective, diverses variantes des bornes d'entrée-sortie d'un filtre selon l'invention;
- la figure 4 est une coupe longitudinale d'un filtre selon l'invention, les faces principales du substrat étant recouvertes chacune d'un capot;
- la figure 5 est une vue en perspective d'une variante d'un filtre selon l'invention;
- la figure 6 est une vue de dessus d'une autre variante d'un filtre selon l'invention;
- la figure 7 est une vue en coupe longitudinale de cette dernière variante.

Sur toutes les figures les mêmes repères représentent les mêmes éléments.

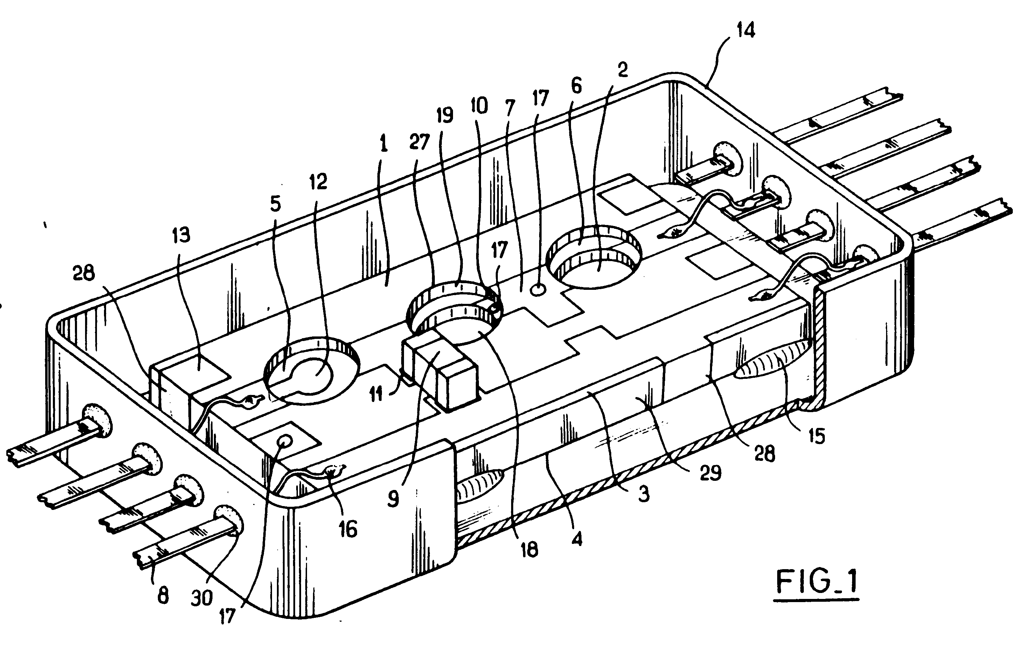

La figure 1 représente une vue en perspective d'un filtre à résonateurs, utilisant l'effet piézoélectrique, conforme à l'invention.

Dans la présente invention, on entend par lame vibrante, soit une lame en matériau piézoélectrique qui se déforme sous l'effet d'un champ électrique, soit une lame non piézoélectrique possédant sur chacune de ses faces principales un transducteur piézoélectrique. Les déformations de la lame non piézoélectrique sont générées par les transducteurs. Les lames vibrantes peuvent être réalisées en quartz, tantalate de lithium, berlinite etc... lorsqu'elles sont piézoélectriques. Lorsqu'elles ne sont pas piézoélectriques, elles peuvent être en saphir par exemple.

Un substrat 1 monobloc est percé de trous 2 à travers ses faces principales 3,4. Le nombre de tours 2 est supérieur ou égal à un. Une lame vibrante 5 est placée dans chaque trou 2. Sur la figure 1, une seule lame vibrante a été représentée afin de faciliter la compréhension de la structure et de ne pas surcharger la figure. Le substrat est en matériau diélectrique tel que la céramique, l'alumine, la silice ou le quartz par exemple.

Chaque trou 2 est constitué de deux évidements 18, 19 de taille différente, placés en vis à vis. Le premier évidement 19 situé sur la face supérieure 3 du substrat 1 est plus grand que la surface de la lame vibrante 5. Le deuxième évidement 18, situé sur la face inférieure 4 du substrat 1 présente une découpe fournissant au moins une surface d'appui 6 pour la lame vibrante 5. Cette surface d'appui 6 est située à un niveau intermédiaire entre les deux faces principales 3,4 du substrat 1.

Le substrat 1 porte sur ses faces principales 3,4 et sur les surfaces d'appui 6, des connexions 7. Ces connexions 7 permettent de relier électriquement des bornes d'entrée-sortie 13 à des composants 9 actifs ou passifs et aux lames vibrantes 5. ces connexions 7 sont généralement des pistes conductrices. Elles sont consitutées de métaux tels que l'argent, le tungstène, le molybdène, l'or, ou d'alliages tels que l'argentpalladium etc.... Ces pistes peuvent être réalisées par exemple, par laquage, évaporation ou cuisson simultanée avec le substrat 1 lorsqu'il est en céramique. Le dessin des connexions 7 dépend du schéma du filtre et la présente invention n'est pas limitée à un schéma particulier. La continuité entre une connexion 7 située sur une face principale 3,4 du substrat 1 et une connexion 7 située sur une surface d'appui 6 se fait par métallisation de la paroi verticale 10 de l'évidement correspondant. Il est également possible de relier une connexion 7 située sur la face inférieure 4 du substrat 1 à une connexion 7 située sur une surface d'appui 6 par l'intermédiaire d'un trou métallisé 17. Ce trou métallisé 17 traverse le substrat 1 entre sa face inférieure 4 et la surface d'appui 6.

De la même manière, la liaison entre deux connexions 7 situées chacune sur une face principale 3,4 peut se faire soit par un trou métallisé 17 à travers le substrat 1, soit par un chemin conducteur 28 passant par une tranche 29 du substrat 1 située sur son bord ou par une tranche 27 du substrat 1 située au bord d'un trou 2. Ce chemin conducteur 28 peut être réalisé par métallisation comme pour les connexions 7 ou par dépot de colle conductrice.

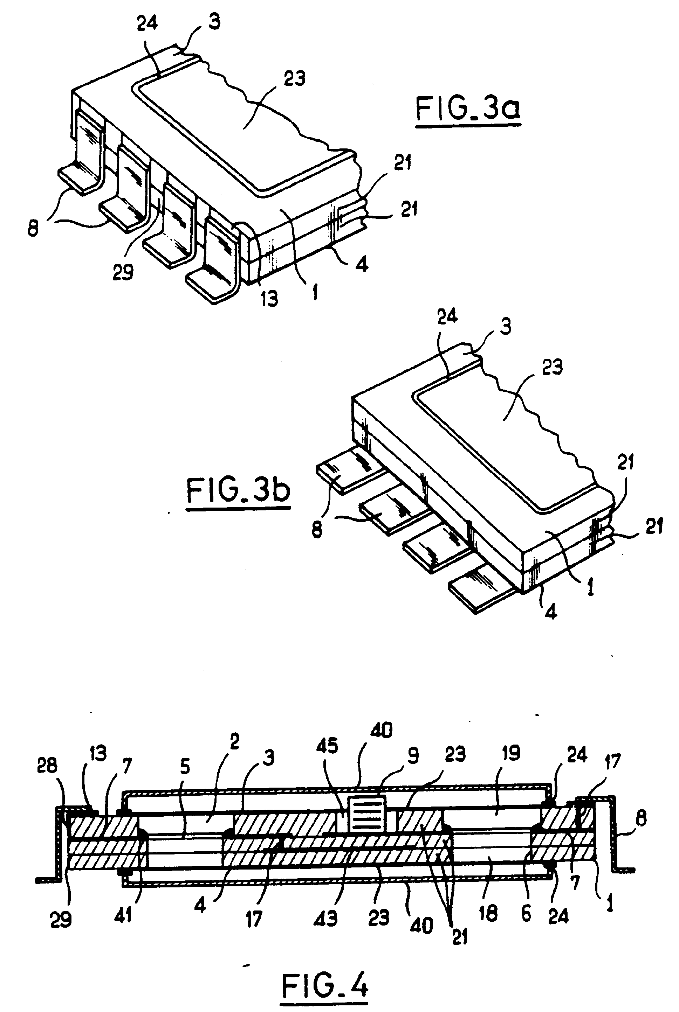

Une lame vibrante 5 est placée dans chaque trou 2. Elle est fixée mécaniquement au dessus de la surface d'appui 6 par au moins deux points d'attache. La lame vibrante 5 est reliée électriquement aux connexions 7. Les points d'attache peuvent servir de points de contact électrique. Ces points d'attache sont représentés en 41 sur la figure 4. Ils peuvent être réalisés par des points de colle conductrice ou par des pinces, fourches, supports ou ressorts métalliques.

Une lame vibrante 5 peut correspondre à un ou à plusieurs résonateurs. Il est fréquent qu'une lame vibrante corresponde à deux résonateurs couplés mécaniquement. Les lames vibrantes 5 portent sur leurs faces principales des dépôts métalliques 12 afin de former des cavités résonantes, un piégeage des modes de résonance et le couplage mécanique entre deux résonateurs lorsqu'ils sont placés sur la même lame vibrante 5. Ces dépots métalliques 12 peuvent être réalisés avant le montage des lames vibrantes 5 mais il est particulièrement intéressant de les réaliser après leur montage dans les trous 2. Cela permet en effet, de faire le réglage de chaque résonateur pendant la métallisation. Ces métallisations sont généralement effectuées par projection de métal sous vide, à travers un masque, la lame vibrante 5 étant sous tension. Dans ce cas, les faces principales 3,4 du substrat 1 peuvent servir de plan d'appui pour les masques. La profondeur de chaque évidemment 18,19 fixe la distance minimum entre la lame vibrante 5 et le masque. Aucun masque n'a été représenté. Selon une variante, l'évidemment 18 situé sur la face inférieure 4 du substrat 1 peut avoir la forme de la métallisation que l'on veut déposer sur la face inférieure de la lame vibrante 5. Dans ce cas il n'est plus nécessaire d'utiliser un masque. Cette variante n'est pas représentée.

Un ou plusieurs composants sont insérés dans le schéma du filtre. Leur nombre est quelconque supérieur ou égal à un. Ces composants servent au couplage, à l'accord, à l'adaptation ou au réglage du filtre. Ces composants sont soit des composants passifs tels que des capacités ou des selfs, par exemple, soit des composants actifs tels que des circuits intégrés. Les composants peuvent être rapportés sur les faces principales 3,4 du substrat 1. Un composant 9 externe est visible sur la figure 1. Ce composant 9 peut être fixé au substrat 1 par collage ou brasage. Les connexions 7 comportent des plages 11 permettant de connecter, par brasage,collage à l'aide d'une colle conductrice ou liaison filaire, les composants 9 externes.

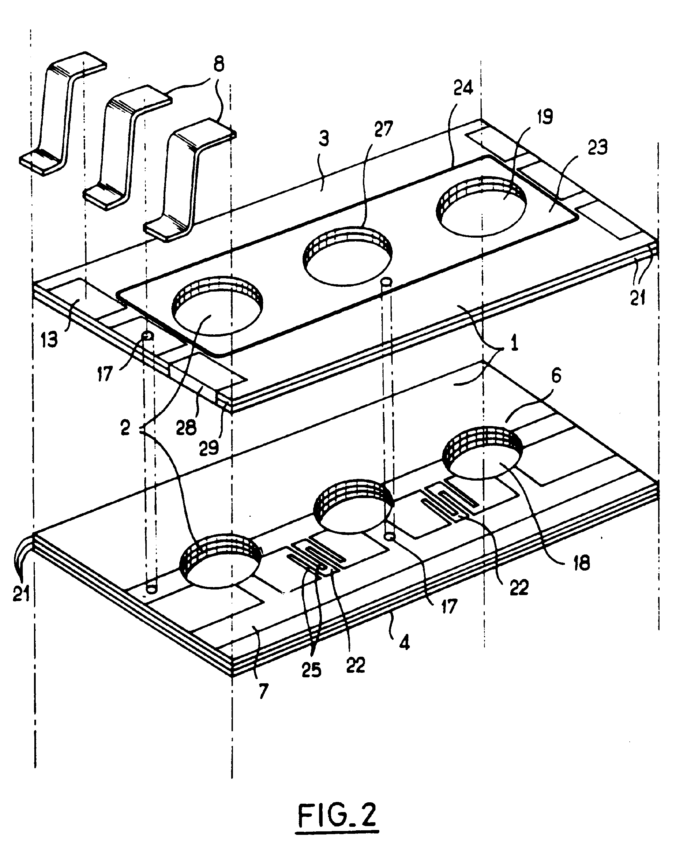

D'autres montages de composants sont décrits aux figures 2,4,5.

Des bornes d'entrée-sortie 13 sont destinées à relier électriquement le substrat 1 à l'extérieur. Elles sont réalisées sous la forme de plages métallisées et sont situées de préférence au bord du substrat 1 soit sur l'une de ses faces principales 3,4 soit sur la tranche 29. Elles sont en nombre quelconque supérieur à un. La liaison entre une borne d'entrée-sortie 13 et une connexion 7 se fait soit directement, soit par l'intermédiaire d'un trou métallisé 17 qui traverse le substrat 1, soit par l'intermédiaire d'un chemin conducteur 28 passant par la tranche 29 du substrat 1.

Le substrat 1 est encapsulé dans un boitier 14 fermé. Le boitier 14 peut être un boitier plat reportable en surface, un boitier embrochable, un boitier support de puce, plus connu sous la dénomination boitier chip carrier, en langue anglaise, etc... Sur la figure 1, il s'agit d'un boitier plat reportable en surface dont on n'a pas représenté le couvercle.

Le substrat 1 est fixé à l'intérieur du boitier 14 par des plots 15 de colle. D'autres types de fixation peuvent être utilisés tels que des ressorts, des pinces etc... .

Des fils 16 assurent la liaison électrique entre les bornes d'entrée-sortie 13 et des connexions externes 8 portées par le boitier 14. Les fils 16 sont soudés, brasés ou collés, d'une part sur les bornes d'entrée-sortie 13 et d'autre part sur les connexions externes 8.

Les connexions externes 8 peuvent être des broches isolées par une perle 30 de verre dans le cas d'un boitier 14 métallique. Dans le cas d'un boitier 14 isolant, les connexions externes 8 peuvent aussi être constituées de saignées métallisées, ménagées sur le pourtour extérieur du boitier 14 lui donnant un contour crénelé. Cette variante n'est pas représentée.

L'atmosphère dans le boitier 14 est constituée par de l'air ou un gaz neutre tel que de l'azote. Il peut être parfois nécessaire, pour le bon fonctionnement du filtre, que le vide règne à l'intérieur du boitier 14.

La figure 2 représente un éclaté partiel d'un filtre à résonateurs selon l'invention dont le substrat 1 est constitué d'un empilement de couches 21. Le nombre de couches 21 est supérieur ou égal à deux. Les couches 21 sont assemblées par collage, par frittage ou par cuisson toutes ensembles, si elles sont en céramique. Le substrat 1 a une structure en sandwich et l'on peut définir des plans situés entre deux couches 21. Le substrat 1 est percé, comme on l'a décrit à la figure 1, de trous 2. Ces trous 2 sont constitués comme précédemment de deux évidements 18,19 et la surface d'appui 6 est située à un niveau intermédiaire qui peut correspondre à la face supérieure d'une couche 21. Les connexions 7, réalisées sous forme de pistes conductrices peuvent maintenant être placées sur les faces de n'importe quelle couche 21.

La liaison électrique entre deux connexions 7 situées dans des plans différents se fait soit par des trous métallisés 17 traversant une ou plusieurs couches 21, soit par un chemin conducteur 28 passant par une tranche 29 d'une ou plusieurs couches 21 située au bord du substrat 1 ou par une tranche 27 d'une ou plusieurs couches 21 située au bord d'un trou 2.

Les bornes d'entrée-sortie 13 sont toujours réalisées sous la forme de plages métallisées, mais sont maintenant situées sur n'importe quelle couche 21 du substrat 1 pourvu qu'elles soient accessibles de l'extérieur.

Comme dans le réalisation précédente, on peut relier une connexion 7 à une borne d'entrée-sortie 13, elle même reliée à une connexion externe 8. Sur la figure 2 les connexions externes 8 sont des broches et les bornes d'entrée-sortie 13 sont situées sur la face supérieure 3 du substrat 1.

Sur cette figure des composants 22 planaires sont réalisés directement à la surface d'une couche 21 par métallisation d'un motif par sérigraphie par exemple. Ces composants 22 sont des capacités interdigitées. Le couplage se fait par proximité entre deux doigts 25, le matériau de la couche servant de diélectrique. Il est également possible de réaliser des selfs planaires.

Parmi les connexions 7, au moins une est portée à une masse. Il est intéressant de réaliser un blindage 23 électromagnétique du substrat 1 en métallisant et en portant à la masse certaines parties du substrat ne comportant pas de connexion. Ce blindage 23 peut être situé sur les faces principales 3,4 du substrat 1 ou entre deux couches 21.

Le substrat 1 au lieu d'être introduit dans un boitier peut être muni d'au moins un capot 40 sur chacune ses faces principales 3,4. Les capots 40 ne sont pas représentés sur la figure 2 mais ils sont visibles sur la figure 4. Ces capots 40 assurent la protection du filtre. A l'intérieur des capots 40 peut régner le vide si l'utilisation ou le fonctionnement du filtre le nécessitent. S'il y a plusieurs capots 40 sur chaque face 3,4 chacun d'entre eux peut recouvrir un trou 2 ou un espace plus grand. Les capots 40 peuvent être métalliques ou en matériau isolant tel que de la céramique. Dans ce dernier cas, le capot 40 peut être métallisé. Les capots 40 sont fixés au substrat 1 par collage, par soudure électrique ou laser, ou par brasage, par exemple. Lorsque le capot 40 est brasé, on dépose au préalable sur le substrat 1 un anneau 24 métallisé, dit anneau de scellement qui permet le brasage. Cet anneau 24 est l'empreinte sur le substrat 1 de la zone de scellement du capot 40. Les capots 40 étant généralement reliés à la masse, dans le cas d'un capot brasé sur le substrat, l'anneau 24 de scellement sera relié à une connexion 7 de masse ou au plan de blindage 23, s'il existe, par les moyens de connexion déjà décrits.

Lorsque le capot 40 est collé sur le substrat 1 l'anneau 24 de scellement n'est plus indispensable mais il faut utiliser au moins, en un point, de la colle conductrice pour relier le capot 40 à la masse.

Lorsque le capot 40 est soudé électriquement ou par laser au substrat 1, l'anneau 24 de scellement est remplacé par un cadre métallique plus épais, en Kovar par exemple. On peut insérer un cadre en céramique entre le cadre métallique et le substrat. Le cadre en céramique permet d'absorber le gradient thermique apparaissant lors de la fermeture du capot 40, la soudure entrainant une importante élévation de température.

Lorsque l'on désire métalliser les lames vibrantes 5 une fois qu'elles sont en place, il est préférable de blinder une zone située autour de chaque trou 2 sur les faces principales 3,4 du substrat 1. A cet effet, le contact entre le masque et le blindage 23 permet de simuler, pendant le réglage du résonateur, le blindage, dû au capot 40 porté à la masse, lorsque celui-ci sera fermé.

Les figures 3a et 3b représentent une vue partielle en perspective d'un filtre selon l'invention. On a représenté un substrat 1 constitué de deux couches 21 et sur sa face principale supérieure 3 un anneau de scellement 24 et un blindage 23. Sur la figure 3a, les connexions externes 8 sont fixées aux bornes d'entrée-sortie 13 situées au bord du substrat 1 sur sa tranche 29.

Les connexions externes 8 sont des broches. Sur la figure 3b, les connexions externes 8 sont fixées aux bornes d'entrée-sortie 13 situées au bord du substrat 1 sur sa face principale inférieure 4. Les bornes d'entrée-sortie 13 ne sont donc pas visibles. Les connexions externes 8 pourraient aussi être constituées de saignées métallisées ménagées sur la tranche 29 du substrat 1, lui donnant un contour crénelé.

Les connexions externes 8 pourraient être simplement des fils que l'utilisateur disposerait, selon ses besoins, sur les bornes d'entrée-sortie 13. Ces deux variantes ne sont pas représentées.

La figure 4 représente en coupe longitudinale un filtre à résonateurs selon l'invention. Le substrat 1 est composé de trois couches 21 empilées les une sur les autres et est percé de deux trous 2. Ces trous 2 ont toujours la même structure. Les lames vibrantes 5 sont déposées au dessus de la surface d'appui 6 et fixées par des points de colle conductrice 41. Un capot 40 recouvre chaque face principale 3,4 du substrat 1. Chaque capot 40 est brasé au substrat 1 par l'intermédiaire d'un anneau de scellement 24. Un blindage 23 recouvre les faces principales du substrat 1 dans une zone située, sur la figure, à l'intérieur des capots. Les connexions externes 8 sont reportées sur les bornes d'entrée-sortie 13 situées sur la face supérieure 3 du substrat 1, sur son bord. Des connexions 7 placées entre deux couches 21 sont reliées aux bornes d'entrée-sortie 13 par l'intermédiaire d'un chemin conducteur 28 placé sur une tranche 29 du substrat 1 sur son bord ou par l'intermédiaire d'un trou métallisé 17 traversant la ou les couches 21.

Sur cette figure, un composant passif 43 a été représenté. Il a une morphologie non planaire. Il a été réalisé par métallisation directe d'un motif à la surface de plusieurs couches 21, par sérigraphie par exemple. Il est ainsi possible de réaliser des capacités multicouches, l'épaisseur d'une couche servant de diélectrique. Des selfs ayant la forme d'un solénoïde peuvent aussi être réalisées. Les différentes spires sont placées sur des couches voisines. Les passages d'une couche à l'autre se font par des trous métallisés 17.

Un autre composant 9 a été représenté. Il s'agit d'un composant actif ou passif, volumineux reporté sur le substrat 1. Pour s'affranchir des problèmes d'épaisseur, ce composant 9 est placé dans un évidement 45 découpé sur une des faces principales 3,4 du substrat 1. La profondeur de l'évidement 45 dépend de l'épaisseur du composant 9. Lorsque le substrat 1 est constitué d'un empilement de couches 21, l'évidement 45 peut traverser plusieurs couches 21. Lorsque le substrat 1 est monobloc, l'évidement 45 est creusé dans le substrat 1.

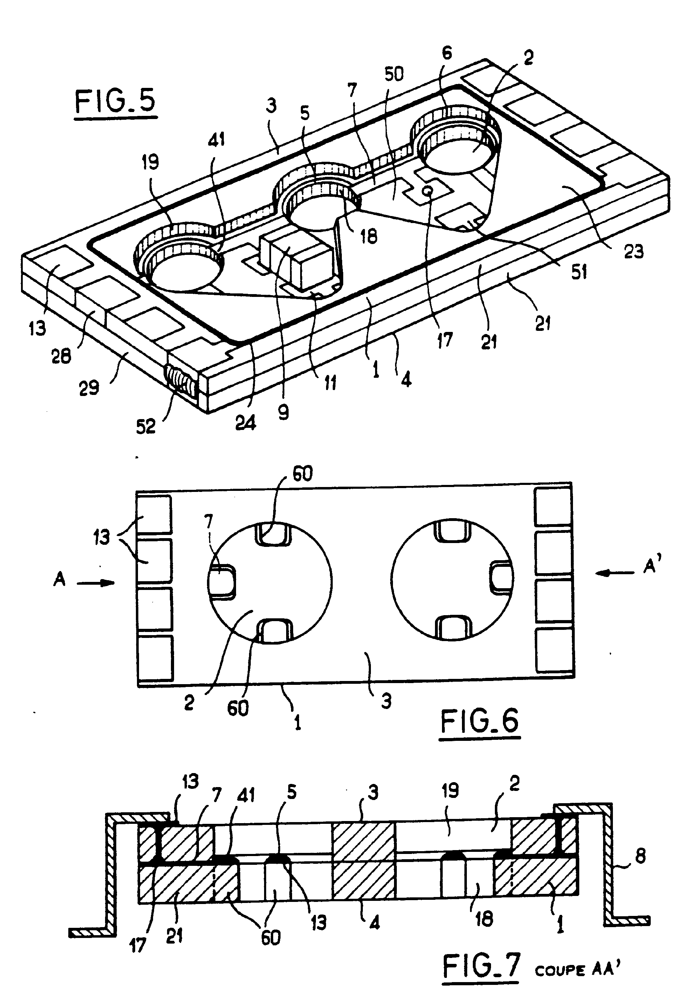

La figure 5 représente en perspective une variante d'un filtre à résonateurs selon l'invention. Le substrat 1 est composé de deux couches 21. Il est percé de trois trous 2. Sur cette figure, les premiers évidements 19 situés sur la face supérieure 3 du substrat 1 se rejoignent pour former une large zone évidée 50. Les lames vibrantes 5 sont fixées dans les trous 2, comme on la vu précédemment. On peut placer, à l'intérieur de la zone évidée 50, des composants externes 9, des composants planaires, des connexions 7, des plages métallisées 51 reliées aux connexions 7 etc... . Ces plages métallisées 51 peuvent servir à effectuer des tests. Elle peuvent être reliées à des connexions 7 ne se trouvant pas dans le même plan par un des moyens déjà décrit. Cette zone évidée 50 peut également être utile pour éviter de recouvrir de matériau diélectrique certaines connexions 7, sensibles aux effets de capacités parasites engendrées par la proximité avec une masse.

Un dépot 52 de colle conductrice ou de soudure peut être realisé sur une tranche 29 du substrat 1 lorsque l'on désire relier électriquement par un chemin conducteur 28 soit deux connexions 7 situées dans des plans différents, soit une connexion 7 et une borne d'entrée-sortie 13. Ce dépot permet les contacts électriques.

La figure 6 représente en vue de dessus une autre variante d'un filtre à résonateurs selon l'invention.

L'évidement 18 situé sur la face inférieure 4 du substrat 1 a une forme particulière. La surface d'appui 6 a été découpée de manière à ce qu'au moins deux plots 60 fassent saillie vers l'intérieur d'un trou 2. Ces plots 60 soutiennent la lame vibrante 5. Ils peuvent porter des connexions 7. Cette réalisation améliore de façon sensible le comportement des lames vibrantes 5, lorsque le filtre est sous contrainte mécanique externe.

La figure 7 représente une coupe longitudinale selon l'axe AA' de la même variante. Le substrat 1 comporte deux couches 21 empilées.

De manière générale le substrat 1 a une épaisseur d'environ 0,6 millimètre. Les couches de céramiques que l'on trouve sur le marché ont une épaisseur de 80 micromètres. Il suffit d'en empiler environ sept pour obtenir un substrat d'épaisseur d'environ 0, 6 millimètre.

La présente invention n'est pas limitée aux réalisations qui viennent d'être décrites. D'autres variantes peuvent entrer dans le cadre de cette invention.

## Revendications

1. Filtre à résonateurs utilisant l'effet piezoélectrique constitué d'un substrat isolant (1) comportant un ou plusieurs composants (9,22,43) actifs ou passifs et au moins une lame vibrante (5) excitée par effet piézoélectrique, disposée dans un trou (2) percé au travers des faces principales (3,4) du substrat (1), des bornes d'entrée-sortie (13), des connexions (7) reliant les bornes d'entrée-sortie (13) à la lame vibrante (5) et au ou aux composants (9,22,43), caractérisé en ce que chaque trou (2) est constitué de deux évidements (18,19) de taille différente, en vis à vis, le premier (19) situé sur la face supérieure (3) du substrat (1) est supérieur ou égal à la surface de la lame vibrante (5), le deuxième (18) situé sur la face inférieure (4) du substrat (1) présente une découpe fournissant au moins une surface d'appui (6), située à un niveau intermédiaire sur laquelle est fixée la lame vibrante (5), par au moins deux points d'attache (41) et en ce que les connexions (7) sont réalisées par des pistes conductrices déposées sur les faces principales (3,4) ou à l'intérieur du substrat (1), et sur la surface d'appui (6).

2. Filtre à résonateurs selon la revendication 1 caractérisé en ce que le substrat (1) est monobloc.

3. Filtre à résonateurs selon la revendication 1 caractérisé en ce que le substrat (1) est constitué d'un empilement d'au moins deux couches (21), assemblées par collage, par frittage ou cuisson toutes ensembles.

4. Filtre à résonateurs selon l'une des revendications 1 à 3 caractérisé en ce que la continuité entre une connexion située sur une face principale (3,4) et une connexion située sur la surface d'appui (6) se fait par métallisation de la paroi verticale de l'évidement (18,19) correspondant.

5. Filtre à résonateurs selon l'une des revendications 1 à 4 caractérisé en ce que le ou les composants sont des composants rapportés (9) ou des composants planaires métallisés (22) situés sur les faces principales (3,4) du substrat (1) ou dans un évidement (45,50) prévu sur le substrat (1).

6. Filtre à résonateurs selon l'une des revendications 1 à 5 caractérisé en ce que les bornes d'entrée-sortie (13) sont constituées de plages métallisées (13) situées au bord du substrat (1) sur ses faces principales (3,4) ou sur une tranche (29).

7. Filtre à résonateurs selon l'une des revendications 1 à 6 caractérisé en ce que la liaison entre deux connexions (7) ou entre une connexion (7) et une borne d'entrée-sortie (13) placées sur des faces différentes (3,4) se fait soit par un trou métallisé (17) traversant le substrat (1), soit par un chemin conducteur (28) déposé sur une tranche (29,27) située respectivement au bord du substrat (1) ou au bord d'un trou (2).

8. Filtre à résonateurs selon l'une des revendications 1 à 7, caractérisé en ce qu'un blindage (23) est réalisé en métallisant et en reliant à une masse certaines parties du substrat (1) où il n'y a pas de connexion (7).

9. Filtre à résonateur selon l'une des revendications 1 à 8, caractérisé en ce que le substrat (1) est muni d'au moins un capot (40) fixé sur chacune de ses faces principales (3,4).

10. Filtre à résonateurs selon l'une des revendications 1 à 9, caractérisé en ce que le second évidement (18), ayant une forme appropriée, constitue un masque à travers duquel la lame est métallisée par projection de métal.

11. Filtre à résonateurs selon la revendication 3, caractérisé en ce que le ou les composants (43) sont obtenus par métallisation de motifs à la surface d'une couche (21) chaque composant (43) pouvant s'étendre sur une ou plusieurs couches (21).

12. Filtre à résonateurs selon l'une des revendications 3 ou 11 caractérisé en ce que les bornes d'entrée-sortie (13) sont des plages métallisées situées sur une ou plusieurs couches (21) de manière à ce que les bornes d'entrée-sortie (13) soient accessibles de l'extérieur.

13. Filtre à résonateurs selon l'une des revendications 3, 11 ou 12, caractérisé en ce que les connexions (7) sont situées entre deux couches (21), la liaison entre deux connexions ou entre une connexion (7) et une borne d'entrée-sortie (13) situées dans des plans différents se fait, soit par un trou métallisé (17) traversant une ou plusieurs couches (21), soit par un chemin conducteur (28) déposé sur une tranche (29,27) située respectivement au bord d'une couche (21) ou au bord d'un trou (2).

**Patentansprüche**

1. Filter mit Resonatoren, das den piezoelektrischen Effekt ausnutzt, mit einem isolierenden Substrat (1), das ein oder mehrere aktive oder passive Bauelemente (9, 22, 43) sowie zumindest eine schwingende Lamelle (5) umfaßt, die durch den piezoelektrischen Effekt erregt wird und in einem Loch (2) angeordnet ist, das durch die Hauptseiten (3, 4) des Substrates (1) hindurchgeführt ist, Eingangs- und Ausgangsklemmen (13) und mit Anschlüssen (7), die die Eingangs- und Ausgangsklemmen (13) mit der schwingenden Lamelle (5) und mit dem oder den Bauelementen (9, 22, 43) verbindet, dadurch gekennzeichnet, daß jedes Loch (2) durch zwei einander gegenüberliegende Aussparungen (18, 19) unterschiedlicher Abmessungen gebildet ist, von denen die erste (19), die an der oberen Seite (3) des Substrates (1) angeordnet ist, größer als oder gleich groß wie die Oberfläche der schwingenden Lamelle (5) ist und die zweite (18), die an der unteren Seite (4) des Substrates (1) angeordnet ist, einen Ausschnitt darstellt, der zumindest eine Stützfläche (6) ergibt, die auf einer Zwischenebene angeordnet ist, auf der die schwingende Lamelle (5) durch zumindest zwei Befestigungspunkte (41) fixiert ist, und daß die Anschlüsse (7) durch Leiterbahnen gebildet sind, die auf den Hauptseiten (3, 4) oder innerhalb des Substrates (1) und auf der Stützfläche (6) angeordnet sind.

2. Filter mit Resonatoren nach Anspruch 1, dadurch gekennzeichnet, daß das Substrat (1) einstückig ausgebildet ist.

3. Filter mit Resonatoren nach Anspruch 1, dadurch gekennzeichnet, daß das Substrat (1) aus einem Stapel von zumindest zwei Schichten (21) gebildet ist, die durch Klebung, Sintern oder Brennen zusammengefaßt sind.

4. Filter mit Resonatoren nach einem der Ansprüche 1 bis 3, dadurch gekennzeichnet, daß die Kontinuität zwischen einem auf der einen Hauptseite (3, 4) angeordneten Anschluß und einem auf der Stützfläche (6) angeordneten Anschluß durch eine Metallisierung der vertikalen Wand der entsprechenden Aussparung (18, 19) erhalten ist.

5. Filter mit Resonatoren nach einem der Ansprüche 1 bis 4, dadurch gekennzeichnet, daß das oder die Bauelemente aufgesetzte Bauelemente (9) oder metallisierte planare Bauelemente (22) sind, die auf den Hauptseiten (3, 4) des Substrates (1) oder in einer auf dem Substrat (1) vorgesehenen Aussparung (45, 50) angeordnet sind.

6. Filter mit Resonatoren nach einem der Ansprüche 1 bis 5, dadurch gekennzeichnet, daß die Eingangs- und Ausgangsklemmen (13) durch metallisierte Bereiche (13) gebildet sind, die am Rand des Substrates auf dessen Hauptseiten (3, 4) oder auf einer Randfläche (29) angeordnet sind.

7. Filter mit Resonatoren nach einem der Ansprüche 1 bis 6, dadurch gekennzeichnet, daß die Verbindung zwischen zwei Anschlüssen (7) oder zwischen einem Anschluß (7) und einer Eingangs- /Ausgangsklemme (13), die auf verschiedenen Seiten (3, 4) angeordnet sind, entweder durch ein das Substrat (1) durchdringendes metallisiertes Loch (17) oder durch einen leitenden Pfad (28) erhalten ist, der auf einer Randfläche (29, 27) angebracht ist, die am Rand des Substrates (1) oder am Rand eines Loches (2) angeordnet ist.

8. Filter mit Resonatoren nach einem der Ansprüche 1 bis 7, dadurch gekennzeichnet, daß eine Abschirmung (23) vorgesehen ist, die dadurch gebildet ist, daß bestimmte Abschnitte des Substrates (1), an denen kein Anschluß (7) vorgesehen ist, metallisiert und mit einer Masse verbunden sind.

9. Filter mit Resonatoren nach einem der Ansprüche 1 bis 8, dadurch gekennzeichnet, daß das Substrat (1) mit zumindest einer Abdeckung (40) versehen ist, die auf einer jeweiligen Hauptseite (3, 4) fixiert ist.

10. Filter mit Resonatoren nach einem der Ansprüche 1 bis 9, dadurch gekennzeichnet, daß die eine entsprechende Form aufweisende zweite Aussparung (18) eine Maske bildet, durch die hindurch die schwingende Lamelle durch Aufspritzen von Metall metallisiert wird.

11. Filter mit Resonatoren nach Anspruch 3, dadurch gekennzeichnet, daß das oder die Bauelemente (43) durch eine Metallisierung von Mustern auf der Oberfläche einer Schicht (21) erhalten sind, wobei sich jedes Bauelement (43) über eine oder mehrere Schichten (21) erstrecken kann.

12. Filter mit Resonatoren nach einem der Ansprüche 3 oder 11, dadurch gekennzeichnet, daß die Eingangs- und Ausgangsklemmen (13) metallisierte Bereiche sind, die auf einer oder mehreren Schichten (21) so angeordnet sind, daß die Eingangs- und Ausgangsklemmen (13) von außen zugänglich sind.

13. Filter mit Resonatoren nach einem der Ansprüche 3, 11 oder 12, dadurch gekennzeichnet, daß die Anschlüsse (7) zwischen zwei Schichten (21) angeordnet sind und daß die Verbindung zwischen zwei Anschlüssen oder zwischen einem Anschluß (7) und einer Eingangs-/Ausgangsklemme (13), die in verschiedenen Ebenen angeordnet sind, entweder durch ein metallisiertes Loch (17) erhalten ist, das eine oder mehrere Schichten (21) durchsetzt, oder durch einen Leiterpfad (28), der auf eine Randfläche (29, 27) aufgebracht ist, die am Rand einer Schicht (21) oder am Rand eines Loches (2) angeordnet ist.

## Claims

1. Filter with resonators using the piezoelectric effect consisting of an insulating substrate (1) comprising one or more active or passive components (9, 22, 43) and at least one vibrating reed (5) excited by the piezoelectric effect, disposed in a hole (2) drilled through the main faces (3, 4) of the substrate (1), input/output terminals (13), connections (7) connecting the input/output terminals (13) to the vibrating reed (5) and to the component(s) (9, 22, 43), characterised in that each hole (2) consists of two recesses (18, 19) of different size, opposite one another, the first (19), situated on the upper face (3) of the substrate (1), is greater than or equal to the surface area of the vibrating reed (5), the second (18), situated on the lower face (4) of the substrate (1), has a cutout providing at least one bearing surface (6), situated at an intermediate level, on which the vibrating reed (5) is fixed by at least two fastening points (41) and in that the connections (7) are produced by conducting tracks deposited on the main faces (3, 4) or inside the substrate (1), and on the bearing surface (6).

2. Filter with resonators according to Claim 1, characterised in that the substrate (1) is monobloc.

3. Filter with resonators according to Claim 1, characterised in that the substrate (1) consists of a stack of at least two layers (21), assembled by gluing, by sintering or baking together.

4. Filter with resonators according to one of Claims 1 to 3, characterised in that continuity between a connection situated on a main face (3, 4) and a connection situated on the bearing surface (6) is made by metallisation of the vertical wall of the corresponding recess (18, 19).

5. Filter with resonators according to one of Claims 1 to 4, characterised in that the component(s) are built-on components (9) or metallised planar components (22) situated on the main faces (3, 4) of the substrate (1) or in a recess (45, 50) provided on the substrate (1).

6. Filter with resonators according to one of Claims 1 to 5, characterised in that the input/output terminals (13) consist of metallised areas (13) situated on the side of the substrate (1) on its main faces (3, 4) or on a side edge (29).

7. Filter with resonators according to one of Claims 1 to 6, characterised in that the link between two connections (7) or between a connection (7) and an input/output terminal (13) placed on different faces (3, 4) is made either by a metallised hole (17) going through the substrate (1), or else by a conducting path (28) deposited on a side edge (29, 27) situated respectively on the side of the substrate (1) or on the side of a hole (2).

8. Filter with resonators according to one of Claims 1 to 7, characterised in that a shield (23) is produced by metallising and by connecting to an earth certain parts of the substrate (1) where there is no connection (7).

9. Filter with a resonator according to one of Claims 1 to 8, characterised in that the substrate (1) is fitted with at least one cap (40) fixed on each of its main faces (3, 4).

10. Filter with resonators according to one of Claims 1 to 9, characterised in that the second recess (18), having a suitable shape, constitutes a mask through which the reed is metallised by spraying metal.

11. Filter with resonators according to Claim 3, characterised in that the component(s) (43) are obtained by metallisation of patterns on the surface of a layer (21), it being possible for each component (43) to extend over one or more layers (21).

12. Filter with resonators according to one of Claims 3 or 11, characterised in that the input/output terminals (13) are metallised areas situated on one or more layers (21) so that the input/output terminals (13) are accessible from outside.

13. Filter with resonators according to one of Claims 3, 11 or 12, characterised in that the connections (7) are situated between two layers (21), the link between two connections or between a connection (7) and an input/output terminal (13) situated in different planes is made either by a metallised hole (17) going through one or more layers (21), or else by a conducting path (28) deposited on a side edge (29, 27) situated respectively on the side of a layer (21) or on the side of a hole (2).

FIG.1

EP 0 356 266 B1

# FIG.2

FIG.3a

FIG.3b

FIG.4

FIG.5

FIG.6

FIG.7 COUPE AA'